# DEMANDE DE BREVET EUROPEEN

(11) **EP 2 937 443 A1**
(43) Date de publication de la demande: **28.10.2015**
(21) Numéro de dépôt: 15305590.0
(22) Date de dépôt: 20.04.2015
(51) Int. Cl.: C23C 14/24, C23C 14/54, C23C 14/56, C23C 14/26, B65D 1/00, B65D 17/00

(54) **CELLULE D'ÉVAPORATION**

(30) Priorité: 24.04.2014 FR 1453687
(71) Demandeur: RIBER, 95873 Bezons Cedex (FR)
(72) Inventeur: Esteve, David, 78380 Bougival (FR); Stemmelen, Franck, 95490 Vaureal (FR)
(74) Mandataire: Coralis Harle

(57) **Abrégé**

La présente invention concerne une cellule d'évaporation (10) qui est destinée à évaporer un matériau (7) sur un substrat (2) placé dans une chambre de dépôt sous vide (20) et qui comporte une enceinte interne (100) délimitant une chambre d'évaporation (100) pour accueillir un creuset (110) qui contient le matériau et présentant une ouverture d'insertion (12) du creuset dans la chambre d'évaporation ; des moyens d'évaporation (131, 132) disposés à la périphérie de l'enceinte interne pour mettre le creuset en conditions d'évaporation ; un conduit d'injection (14) pour transporter un flux de vapeur du matériau évaporé depuis la chambre d'évaporation jusqu'à un injecteur (13) situé dans la chambre de dépôt sous vide ; et une vanne d'arrêt (17) placée sur ledit conduit d'injection. Selon l'invention, la cellule d'évaporation comporte des moyens d'obturation (105, 105A) de l'ouverture d'insertion qui présentent une configuration ouverte pour l'insertion du creuset dans la chambre d'évaporation et une configuration fermée dans laquelle la chambre d'évaporation est confinée et en communication avec la chambre de dépôt sous vide *via* le conduit d'injection, et des moyens d'ouverture (18) pour ménager une ouverture d'évaporation dans une enveloppe du creuset qui est remplie du matériau à évaporer et maintenue sous vide de sorte que le creuset est alors en communication avec la chambre d'évaporation.

## Description

L'invention concerne le domaine de l'évaporation et du dépôt sous vide de matériaux sur un substrat.

L'invention concerne plus particulièrement une cellule d'évaporation destinée à évaporer un matériau en vue de son dépôt sur un substrat placé dans une chambre de dépôt sous vide.

On connaît du document EP 1 825 018 un appareil de dépôt sous vide comportant une cellule d'évaporation qui est destinée à évaporer un matériau en vue de son dépôt sur un substrat placé dans une chambre de dépôt sous vide et qui comporte :
- une enceinte interne délimitant une chambre d'évaporation adaptée à accueillir un creuset contenant ledit matériau à évaporer, cette enceinte interne présentant une ouverture d'insertion du creuset dans ladite chambre d'évaporation,
- des moyens d'évaporation disposés à la périphérie de ladite enceinte interne et adaptés à mettre ledit creuset en conditions d'évaporation pour l'évaporation du matériau contenu dans ledit creuset, lorsque celui-ci est accueilli dans ladite chambre d'évaporation,
- un conduit d'injection adapté à transporter un flux de vapeur du matériau évaporé depuis la chambre d'évaporation jusqu'à un injecteur situé dans ladite chambre de dépôt sous vide, et
- une vanne d'arrêt placée sur ledit conduit d'injection,

Un tel appareil de dépôt sous vide permet de déposer un matériau ou composé semi-conducteur (par exemple : silicium, arséniure de gallium, phosphure d'indium, *etc...*), un matériau inorganique (par exemple : sélénium, antimoine, phosphore), ou un matériau organique (par exemple : tris (8-hydroxyquinoléine) aluminium (III) ou Alq3, ...).

La cellule d'évaporation du document EP 1 825 018 permet, lorsque la vanne d'arrêt est fermée, de raccorder le creuset au conduit d'injection sans remise à l'air de la chambre de dépôt sous vide.

À cet effet, le creuset est une bouteille dont le goulot est adapté à être vissé de manière étanche sur un embout du conduit d'injection.

Cependant, avec la cellule d'évaporation du document EP 1 825 018, lors de l'ouverture de la vanne d'arrêt, il se produit un pic de pression issu du volume d'air emprisonné dans le creuset et dans la portion du conduit d'injection proche de l'embout qui s'échappe dans la chambre de dépôt maintenu sous vide.

Ce pic de pression peut dégrader la qualité de la couche déposée sur le substrat de sorte que le rendement de production est médiocre.

Afin de remédier à l'inconvénient précité de l'état de la technique, la présente invention propose une cellule d'évaporation permettant de réduire, voire de supprimer, le pic de pression lors du chargement de cette cellule d'évaporation par un creuset plein.

À cet effet, l'invention concerne une cellule d'évaporation telle que précitée qui comporte :
- des moyens d'obturation de ladite ouverture d'insertion de l'enceinte interne de la cellule d'évaporation, ces moyens d'obturation présentant :
   - une configuration ouverte permettant l'insertion dudit creuset dans ladite chambre d'évaporation, et
   - une configuration fermée dans laquelle la chambre d'évaporation est confinée et en communication avec la chambre de dépôt sous vide *via* le conduit d'injection lorsque la vanne d'arrêt est ouverte, et
- des moyens d'ouverture adaptés à ménager une ouverture d'évaporation dans une enveloppe dudit creuset qui est remplie du matériau à évaporer et maintenue sous vide avant ouverture, ladite ouverture d'évaporation permettant de mettre ledit creuset en communication avec ladite chambre d'évaporation.

La cellule d'évaporation selon l'invention permet donc de changer le creuset accueilli dans la chambre d'évaporation en limitant l'intensité du pic de pression provoqué par l'ouverture de la vanne d'arrêt.

En effet, le creuset présentant une enveloppe scellée préalablement mise sous vide et remplie du matériau à évaporer, réduit ainsi considérablement le volume résiduel compris entre l'enceinte interne de la cellule d'évaporation et l'enveloppe du creuset qui est emprisonné dans la cellule d'évaporation après insertion du creuset dans la chambre d'évaporation et après obturation de l'ouverture d'insertion grâce aux moyens d'obturation.

De manière avantageuse, les dimensions respectives de la chambre d'évaporation et du creuset sont ajustées de telle sorte que ce volume résiduel soit inférieur au volume intérieur dudit creuset.

De cette façon, le volume d'air chassé lors de l'insertion du creuset dans la chambre d'évaporation est faible par rapport au volume total de l'enceinte interne de sorte que le pic de pression est atténué lors de l'ouverture de la vanne d'arrêt.

De manière avantageuse également, les dimensions respectives de la chambre d'évaporation et du creuset sont ajustées de telle sorte que la somme du volume résiduel, compris entre ladite enceinte interne de la cellule d'évaporation et ladite enveloppe du creuset, et du volume additionnel délimité par la portion du conduit d'injection comprise entre ladite chambre d'évaporation et ladite vanne d'arrêt, soit inférieure au volume intérieur dudit creuset.

Par ailleurs, d'autres caractéristiques avantageuses et non limitatives de la cellule d'évaporation selon l'invention sont les suivantes :
- ladite cellule d'évaporation comporte une enceinte externe enveloppant ladite enceinte interne, lesdits moyens d'évaporation, et ladite vanne d'arrêt et présentant une ouverture de passage en regard ou confondue avec ladite ouverture d'insertion de l'enceinte interne pour permettre le passage dudit creuset en vue de son insertion dans ladite chambre d'évaporation ;
- lesdits moyens d'obturation de la cellule d'évaporation passent de leur configuration ouverte à leur configuration fermée à la faveur de l'insertion dudit creuset dans ladite chambre d'évaporation ;
- lesdits moyens d'obturation de la cellule d'évaporation comprennent une plaque de fermeture munie d'un élément de joint destiné à réaliser l'étanchéité entre ladite plaque de fermeture et ladite enceinte interne ;
- lesdits moyens d'ouverture de la cellule d'évaporation comprennent un pointeau de perforation destiné à percer un opercule étanche de ladite enveloppe sous vide du creuset ;
- il est prévu des moyens de pompage supplémentaires de ladite enceinte interne qui sont adaptés à faire le vide dans ladite chambre d'évaporation ;
- il est prévu des moyens d'échappement de ladite enceinte interne qui sont adaptés à remettre à l'air ladite chambre d'évaporation ;
- ladite cellule d'évaporation comporte en outre une chambre de chargement attenante à la chambre d'évaporation pour l'engagement et le désengagement dudit creuset d'avec la chambre d'évaporation, ladite chambre de chargement étant en communication avec la chambre d'évaporation au travers de ladite ouverture d'insertion ;
- il est également prévu des moyens de blindage thermique qui s'interposent entre ladite enceinte externe et ladite chambre de chargement et qui sont adaptés à isoler thermiquement ladite chambre d'évaporation de ladite chambre de chargement.

Des modes de réalisation de l'invention seront décrits en détail en référence aux dessins dans lesquels :
- la figure 1 est une vue schématique d'ensemble en coupe dans un plan vertical d'un appareil de dépôt sous vide comportant une cellule d'évaporation conforme à un premier mode de réalisation de l'invention ;
- la figure 2 est une vue de détail de la zone II de la figure 1 montrant les moyens d'obturation, les moyens d'évaporation de la cellule d'évaporation de la figure 1 ;
- la figure 3 est une vue schématique en coupe dans un plan vertical d'un creuset plein avant engagement dans la chambre d'évaporation de la cellule d'évaporation de la figure 1 ;
- la figure 4 est une vue schématique en coupe dans un plan vertical d'une cellule d'évaporation selon une première variante dans laquelle une pompe et une soupape sont branchées sur la chambre d'évaporation ;
- la figure 5 est une vue schématique en coupe dans un plan vertical d'une cellule d'évaporation selon une deuxième variante dans laquelle le creuset comporte un joint destiné à obturer l'ouverture d'insertion ;
- la figure 6 est une vue schématique en coupe dans un plan vertical d'une cellule d'évaporation selon un deuxième mode de réalisation de l'invention dans lequel la cellule d'évaporation comporte en outre une chambre de chargement pour le rechargement des creusets.

Dans l'exposé qui va suivre, les termes « haut » et « bas » seront utilisés par référence à la verticale, relativement au local dans lequel l'appareil de dépôt sous vide est installé, le haut désignant le côté tourné vers le plafond du local et le bas désignant le côté tourné vers le plancher. De même, les termes « inférieur » et « supérieur » désigneront les côtés tournés respectivement vers le bas et vers le haut.

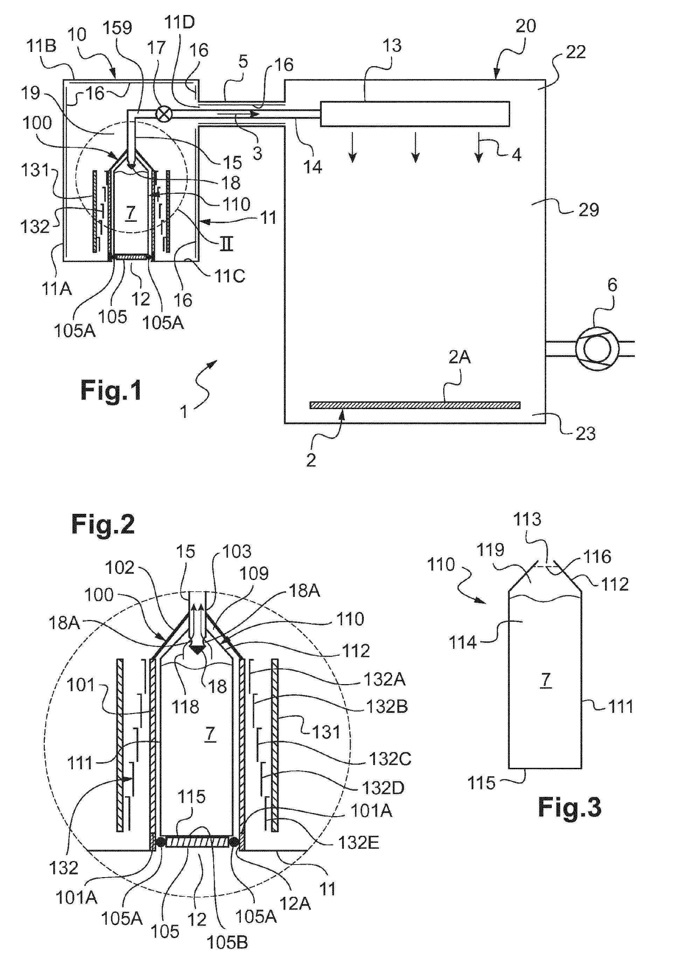

On a représenté sur la figure 1 une vue schématique d'ensemble en coupe dans un plan vertical d'un appareil de dépôt sous vide 1 qui comporte, d'une part, une cellule d'évaporation 10, et, d'autre part, une chambre de dépôt sous vide 20.

De manière générale, la cellule d'évaporation 10 de l'appareil de dépôt sous vide 1 est destinée à évaporer un matériau 7 en vue de son dépôt sur un substrat 2 placé dans la chambre de dépôt sous vide 20, ici dans une partie basse 23 de celle-ci.

On verra dans la suite de la description que la cellule d'évaporation 10 est conçue pour générer un flux de vapeur amont 3 dudit matériau 7, flux de vapeur amont 3 qui est transporté par un conduit d'injection 14 depuis la cellule d'évaporation 10 jusqu'à un injecteur 13 situé dans la partie haute 22 de la chambre de dépôt sous vide 20.

La cellule d'évaporation 10 et la chambre de dépôt sous vide 20 sont connectées l'une à l'autre par un raccord tubulaire 5 traversé par le conduit d'injection 14.

L'injecteur 13 de la cellule d'évaporation 10 injecte la vapeur de matériau 7 transportée par le conduit d'injection 14 dans la chambre de dépôt sous vide 20 selon un flux de vapeur aval 4 dirigé vers le bas en direction du substrat 2, de sorte que le matériau 7 se dépose sur une face supérieure 2A du substrat 2 tournée vers l'injecteur 13.

Il est tout aussi envisageable d'avoir le flux de vapeur aval se dirigeant vers le haut et se déposant sur une face inférieure du substrat.

L'injecteur 13 est conçu pour optimiser les caractéristiques du flux de vapeur aval 4 dirigé vers le substrat 2, par exemple son débit ou sa distribution spatiale, de sorte que la couche de matériau 7 déposée sur la face supérieure 2A du substrat 2 présente les propriétés requises comme l'épaisseur, l'état de surface, la conductivité, l'uniformité, etc..., en fonction de l'application visée.

Il est prévu à l'intérieur de l'injecteur 13 des moyens spécifiques de chauffage (non représentés) destinés à éviter la condensation des vapeurs de matériau 7 à l'intérieur de l'injecteur 13, ce qui pourrait compromettre son bon fonctionnement.

Afin de réaliser et de maintenir le vide à l'intérieur de la chambre de dépôt sous vide 20, l'appareil de dépôt sous vide 1 comporte des moyens de pompage 6 branchés sur la chambre de dépôt sous vide 20 dont les capacités de pompage sont ajustées en fonction du volume intérieur 29 de la chambre de dépôt sous vide 20.

Ces moyens de pompage 6 comprennent ici une pompe turbo-moléculaire ou une pompe cryogénique qui font descendre le niveau de pression régnant à l'intérieur de la chambre de dépôt sous vide 20 jusqu'à 10⁻³ à 10⁻⁸ Torr.

On va maintenant décrire en référence aux figures 1 à 5, un premier mode de réalisation de cellule d'évaporation 10 destinée à produire un flux de vapeur aval 3 en direction de l'injecteur 13.

Comme représenté sur la figure 1, la cellule d'évaporation 10 de l'appareil de dépôt sous vide 1 comporte tout d'abord une enceinte externe 11, ici de forme globalement cylindrique, comprenant une paroi latérale 11 A, une paroi supérieure 11 B (ou « *toit* »), et une paroi inférieure 11C (ou « *fond »*).

Il est prévu, sur les faces internes de la paroi latérale 11 A et de la paroi supérieure 11 B de l'enceinte externe 11, et aussi du raccord tubulaire 5, des éléments chauffants, par exemple des résistances chauffantes 16, destinés à chauffer de façon sensiblement homogène le volume intérieur 19 de l'enceinte externe 11, en particulier le conduit d'injection 14, de manière à éviter que les vapeurs de matériau 7 ne se condensent sur des parties froides de la cellule d'évaporation 10.

Il est également prévu, cette fois sur les faces externes de la paroi latérale 11 A, de la paroi supérieure 11 B, de la paroi inférieure 11C, et aussi du raccord tubulaire 5, des éléments refroidissants (non représentés), par exemple des serpentins d'eau froide, de sorte que l'enceinte externe 11 de la cellule d'évaporation 10 soit froide au toucher depuis l'extérieur.

Entre les éléments chauffants 16 et les éléments refroidissants, est inséré un écran radiatif, par exemple réalisé sous la forme d'un matériau réfractaire, de sorte que le chauffage et le refroidissement soient efficaces chacun de leur côté.

La paroi latérale 11 A comprend une ouverture 11 D de laquelle s'étend vers l'extérieur le raccord tubulaire 5 pour la connexion de la cellule d'évaporation 10 avec la chambre de dépôt sous vide 20 de l'appareil de dépôt sous vide 1.

Dans cette configuration, l'enceinte externe 11 et la chambre de dépôt sous vide 20 sont en communication et partagent le même vide si bien que lorsque le vide est fait à l'intérieur de la chambre de dépôt sous vide 20, il est également fait à l'intérieur de l'enceinte externe 11 de la cellule d'évaporation 10. Le niveau de pression dans cette enceinte externe 11 est ainsi égal à celui régnant dans la chambre de dépôt sous vide 20.

En variante, on peut prévoir une soudure étanche entre le raccord tubulaire et le conduit d'injection de la cellule d'évaporation, de sorte que l'enceinte externe de la cellule d'évaporation ne partage pas le même vide que la chambre de dépôt sous vide. Dans ce cas, la cellule d'évaporation comprend alors une pompe d'enceinte qui lui est dédiée et qui est destinée à pomper le volume intérieur de l'enceinte externe pour faire chuter la pression jusqu'à un niveau de l'ordre de 10⁻³ à 10⁻⁸ Torr.

Comme cela est visible sur les figures 1, 2, 4, et 5, une ouverture, appelée par la suite ouverture de passage 12, est ménagée dans la paroi inférieure 11C de l'enceinte externe 11.

Cette ouverture de passage 12 présente un bord intérieur 12A, qui est ici de forme circulaire, au-dessus duquel s'étend, vers l'intérieur de l'enceinte externe 11, une chambre d'évaporation de la cellule d'évaporation 10.

Cette chambre d'évaporation est délimitée par une enceinte interne 100 comprenant, d'une part, un corps 101 cylindrique coaxial avec l'ouverture de passage 12, et, d'autre part, un col 102 tronconique prolongeant le corps 101, jusqu'à un bord supérieur 103 de l'enceinte interne 100.

Cette enceinte interne 100 qui, comme le montre bien la figure 1, est enveloppée par l'enceinte externe 11 de la cellule d'évaporation 10, présente une ouverture d'insertion qui est ici confondue avec l'ouverture de passage 12 de l'enceinte externe 11.

En variante, l'ouverture de passage de l'enceinte externe et l'ouverture d'insertion de l'enceinte interne peuvent être distinctes et alors en regard l'une de l'autre.

Le corps 101 de la chambre d'évaporation 100 présente un bord inférieur 101 A qui court sans interruption le long du bord intérieur 12A de l'ouverture de passage 12 (voir figure 2). Le bord inférieur 101 A est hermétiquement fixé sur la paroi inférieure 11C de l'enceinte externe 11 de la cellule d'évaporation 10 de sorte que le volume intérieur 19 de l'enceinte externe 11 de la cellule d'évaporation 10 ne communique pas avec le volume intérieur 109 de l'enceinte interne 100.

Le bord supérieur 103 de l'enceinte interne 100 est connecté de manière étanche à une portion amont 15 du conduit d'injection 14 de la cellule d'évaporation 10 formant ici un coude au niveau bord supérieur 103. Cette portion amont pourrait également être un raccord droit sans coude.

La connexion étanche peut être réalisée, par exemple, au moyen d'une soudure.

La chambre d'évaporation 100 de la cellule d'évaporation 10 est destinée à accueillir un creuset 110 contenant le matériau 7 à évaporer.

Ce creuset 110 a globalement la forme d'une bouteille et présente des dimensions adaptées pour qu'il puisse loger dans la chambre d'évaporation 100.

Le creuset 110 comprend une paroi latérale 111 qui est fermée vers le bas par un fond 115 et qui se rétrécit vers le haut suivant un col 112 délimitant un goulot 113 du creuset 110.

Le creuset 110 est de préférence réalisé d'une seule pièce dans un matériau présentant une bonne conductivité thermique et une résistance aux hautes températures. Il peut être, par exemple, réalisé dans un matériau céramique tel que le nitrure de bore pyrolytique ou PBN (pour *« Pyrolytic Boron Nitride* » en anglais) ou alors dans un matériau de type vitreux tel que le quartz.

Le creuset 110 est destiné à être rempli par le matériau 7 à évaporer, ce matériau 7 pouvant se présenter sous forme liquide, sous forme de poudre, voire sous forme de lingots.

Avant utilisation, le creuset 110 est ici scellé au moyen d'un opercule 116 qui est situé près du goulot 113 du creuset 110 et qui ferme de manière étanche le creuset 110.

On verra dans la suite de la description que cet opercule 116 est destiné à être percé afin de laisser s'échapper les vapeurs du matériau 7 évaporé lorsque le creuset 110 est mis en conditions d'évaporation.

Avant ouverture de cet opercule 116, le fond 115, le corps 111, le col 112 et l'opercule 116 forment ainsi une enveloppe scellée du creuset 110 qui est remplie du matériau 7 à évaporer. Cette enveloppe, après remplissage du creuset 110 avec le matériau 7, est alors mise sous vide et fermée par l'opercule 116 de sorte que le volume intérieur 119 du creuset laissé libre est maintenu, avant ouverture, à une pression comprise entre 10⁻¹ et 10⁻³ mbar.

Une telle mise sous vide du creuset 110 permet notamment d'éviter la dégradation du matériau 7 contenu dans le creuset 110, par exemple lors du remplissage de celui-ci avec un matériau organique qui peut s'oxyder au contact de l'oxygène ou de l'eau contenu dans l'air ambiant.

On verra également que la mise sous vide du creuset 110 permet également de limiter le pic de pression dans la chambre de dépôt sous vide 20 lorsque l'opercule 116 est percé.

Afin de mettre en conditions d'évaporation un creuset 110 engagé dans la chambre d'évaporation 100, la cellule d'évaporation 10 comporte également des moyens d'évaporation disposés à la périphérie de la chambre d'évaporation 100 accueillant le creuset 110 de sorte qu'ici l'enceinte externe 11 enveloppe ces moyens d'évaporation.

Dans tous les modes de réalisation et leurs variantes décrits sur les figures 1 à 6, ces moyens d'évaporation comprennent tout d'abord des résistances électriques 131 entourant la chambre d'évaporation 100 et s'étendant depuis le fond 11C de l'enceinte externe 11, sensiblement parallèlement au corps 101 de la chambre d'évaporation 100, jusqu'au col 102 de celle-ci.

Ces résistances électriques 131 sont alimentées électriquement et portées à haute température de sorte qu'elles rayonnent de la chaleur, essentiellement sous forme infra-rouge.

En variante, les moyens d'évaporation peuvent comprendre des lampes infrarouges placées directement dans le volume intérieur de la chambre d'évaporation, contre le corps de celle-ci, de manière à irradier directement le creuset engagé dans la chambre d'évaporation.

Les moyens d'évaporation comprennent également un écran thermique 132 situé à l'intérieur de l'enceinte externe 11 et interposé entre le corps 101 de l'enceinte interne 100 et les résistances électriques 131.

Comme le montre bien la figure 2, cet écran thermique 132 est de type « télescopique » et comporte ici cinq éléments mobiles 132A, 132B, 132C, 132D, 132E, cylindriques et coaxiaux, qui peuvent s'emboîter les uns dans les autres de sorte que la hauteur de l'écran thermique 132 peut être ajustée à façon.

Par exemple, la figure 2 fait apparaître l'écran thermique 132 selon sa plus grande hauteur, lorsque tous les éléments mobiles 132A, 132B, 132C, 132D, 132E sont dépliés.

Les éléments mobiles 132A, 132B, 132C, 132D, 132E sont ici formés de cylindres réalisés dans le même matériau, par exemple un matériau métallique, tel que l'acier ou l'aluminium.

En variante, les éléments mobiles peuvent être par exemple constitués de cylindres en quartz, en verre ou en silice, dont la face externe tournée vers les résistances électriques est revêtue d'une couche réfléchissant le rayonnement thermique émis par ces résistances électriques, par exemple une couche métallique, telle qu'une couche d'argent, d'aluminium, ou bien d'or.

Les moyens d'évaporation comportent par ailleurs des moyens d'actionnement (non représentés) permettant de faire coulisser les éléments mobiles 132A, 132B, 132C, 132D, 132E les uns par rapport autres pour régler la hauteur de l'écran thermique 132.

Bien que sur les figures 1, 2, et 4 à 6, les éléments mobiles 132A, 132B, 132C, 132D, 132E soient au nombre de cinq et présentent tous la même hauteur, on peut envisager en variante que les moyens d'évaporation comprennent plus ou moins d'éléments mobiles et que ceux-ci présentent des hauteurs différentes. Cela peut notamment être avantageux afin d'adapter la hauteur de l'écran thermique à la hauteur de la chambre d'évaporation et de régler cette hauteur avec plus ou moins de précision.

Les moyens d'évaporation comportent enfin ici le corps 101 cylindrique de l'enceinte interne 100 constitué d'une paroi transparente qui est choisie de manière à transmettre le rayonnement infra-rouge émis par les résistances électriques 131.

Dans les conditions de pression régnant à l'intérieur de l'enceinte externe 11, les échanges de chaleur entre les résistances électriques 131 et le corps 111 du creuset 110 engagé avec la chambre d'évaporation 100 se font essentiellement par rayonnement, car les échanges par convection sont fortement limités du fait du vide régnant l'enceinte externe 11.

Lorsqu'un creuset 110 est engagé avec la chambre d'évaporation 100 (voir figure 2 par exemple), c'est-à-dire lorsqu'il est logé à l'intérieur du volume intérieur 109 de la chambre d'évaporation 100, sa paroi latérale 111 se retrouve alors en regard du corps 101 de la chambre d'évaporation 100, c'est-à-dire de la paroi transparente de l'enceinte interne.

La paroi transparente peut être par exemple formée d'un cylindre creux en en quartz, en verre ou en silice, éventuellement revêtue d'une couche améliorant la transmission infra-rouge de la paroi transparente.

L'écran thermique 132, agencé entre les résistances électriques 131 et cette paroi transparente du corps 101 de la chambre d'évaporation 100, va ainsi agir comme un miroir pour la lumière infra-rouge rayonnée par les résistances électriques 131 en direction du corps 111, 121 d'un creuset 110, 120 se trouvant dans la chambre d'évaporation 100.

Ainsi, grâce à l'écran thermique 132, il est possible de découvrir tout ou partie des résistances électriques 131, de sorte que seule la fraction de matériau 7 contenue dans la partie supérieure 114 du creuset 110 (voir figure 3) soit soumise au rayonnement émis par les résistances électriques et soit chauffée, en fonction de la pression dans la chambre d'évaporation 100, jusqu'à une température de chauffage suffisante pour permettre son évaporation.

De plus, grâce aux moyens d'actionnement faisant coulisser les éléments mobiles 132A, 132B, 132C, 132D, 132E, il est possible de régler finement la hauteur de l'écran thermique 132 pour ajuster en temps réel le flux de vapeur 118 (voir les flèches sur la figure 2) dans la portion amont 15 du conduit d'injection 14.

En particulier, il est possible d'obtenir des conditions d'évaporation dans lesquelles le flux de vapeur 118 demeure sensiblement constant tout au long de l'évaporation du matériau 7 contenu dans le creuset 110. Ceci s'avère particulièrement intéressant pour le dépôt d'une couche uniforme sur le substrat 2 placé dans la chambre de dépôt sous vide 20.

Comme le montrent les figures 1, 2, 4, et 5, la cellule d'évaporation 10 comporte également une vanne d'arrêt 17 placée sur le conduit d'injection 14 de la cellule d'évaporation 10.

De préférence, cette vanne d'arrêt 17 est placée sur le conduit d'injection 14 de manière à être située à l'intérieur de l'enceinte externe 11 de la cellule d'évaporation 10 qui l'enveloppe.

De cette façon, la vanne d'arrêt 17 est chauffée par les résistances chauffantes 16 disposés sur les faces intérieures de l'enceinte externe 11 de manière à limiter la condensation des vapeurs de matériau 7 évaporé sur cette vanne d'arrêt 17.

La vanne d'arrêt 17 peut être par exemple une vanne étanche *« tout-ou-rien »* avec deux positions ouverte et fermée qui permet en position fermée, lorsque la chambre d'évaporation 100 est vide, d'éviter que le flux de vapeur ne revienne vers la chambre d'évaporation 100 pour se condenser sur le corps 101 de l'enceinte interne 100 ce qui peut réduire l'efficacité des moyens d'évaporation à chauffer le creuset 110.

De manière générale, la vanne d'arrêt 17 sert avant tout à isoler la chambre de dépôt sous vide 20 de la chambre d'évaporation 100 de la cellule d'évaporation 10, lorsque cette chambre d'évaporation 100 est ouverte et mise à l'air. De cette façon, grâce à la vanne d'arrêt 17, il est notamment possible de changer de creuset sans remettre à l'air la chambre de dépôt sous vide 20 de l'appareil de dépôt sous vide 1. On conserve un niveau de vide poussé dans la chambre de dépôt sous vide 20 et on évite ainsi toute pollution de celle-ci ou d'un substrat qui s'y trouverait.

De manière avantageuse, on peut prévoir de placer en série sur le conduit d'injection 14 une vanne de régulation en aval de la vanne d'arrêt 17.

Bien que le débit du flux de vapeur en sortie de la chambre d'évaporation 100 soit réglé grâce aux moyens d'évaporation, cette vanne de régulation peut également permettre de régler encore plus finement le débit de vapeur de matériau 7.

Selon l'invention, afin d'éviter une remise à l'air de la chambre de dépôt sous vide 20 et de limiter le pic de pression lors du changement de creuset dans la chambre d'évaporation 100, la cellule d'évaporation 10 comporte, en outre, des moyens d'obturation de l'ouverture d'insertion 12 de l'enceinte interne 100 et des moyens d'ouverture du creuset 110 permettant de ménager une ouverture d'évaporation dans l'enveloppe scellée maintenue sous vide du creuset 110.

À cet effet, les moyens d'obturation présentent une configuration ouverte permettant l'insertion dudit creuset dans ladite chambre d'évaporation 100, et une configuration fermée dans laquelle la chambre d'évaporation 100 est confinée.

Comme représenté schématiquement sur la figure 1 et plus en détail sur la figure 2, les moyens d'obturation comportent ici une plaque de fermeture 105 circulaire comprenant à sa périphérie un joint d'étanchéité 105A.

Cette plaque de fermeture 105 présente une forme et des dimensions adaptées à l'ouverture de passage 12 de l'enceinte externe 11 et à l'ouverture d'insertion 12 de l'enceinte interne 100 de sorte qu'elle peut s'engager dans celles-ci avec le joint 105A s'appuyant sur le bord intérieur 12A de l'ouverture d'insertion 12, fermant ainsi de manière étanche la chambre d'évaporation 100 vis-à-vis de l'extérieur.

La plaque de fermeture 105 est alors dans sa configuration fermée. Lorsque la vanne d'arrêt 17 est ouverte, la chambre d'évaporation 100 est alors confinée et en communication uniquement avec la chambre de dépôt sous vide 20 *via* le conduit d'injection 14. On entend ici par le terme « confinée », le fait que la chambre d'évaporation 100 n'est pas en communication avec l'extérieur de la cellule d'évaporation 10 où règne une pression proche de la pression atmosphérique (1 bar).

Il est également prévu des moyens de blocage (non représentés) permettant de maintenir en position la plaque de fermeture 105 après engagement dans l'ouverture d'insertion 12.

On peut par exemple prévoir de fixer une contre-plaque sur la paroi inférieure 11C de l'enceinte externe 11 de la cellule d'évaporation 10 dont la face supérieure s'appuierait contre la face inférieure de la plaque de fermeture 105 de façon à empêcher celle-ci de se désengager de l'ouverture d'insertion 12.

De manière avantageuse ici, la plaque de fermeture 105 permet de supporter également le creuset 110 lorsque celui-ci est engagé avec la chambre d'évaporation 100. Plus précisément, lorsque le creuset 110 se trouve loger dans l'enceinte interne 100 de la cellule d'évaporation 10, son fond 115 repose sur la face supérieure 105B de la plaque de fermeture 105 (voir figure 2).

Dans des variantes, on peut prévoir des moyens de maintien spécifiques destinés à maintenir le creuset en position dans la chambre d'évaporation après son insertion dans celle-ci.

Par exemple, la plaque de fermeture peut être maintenue en position à l'aide d'un piston. On peut également prévoir que la plaque de fermeture comprend sur son bord périphérique un filetage adapté à coopérer avec un taraudage réalisé dans le bord intérieur de l'ouverture de passage. Dans ce cas, l'assemblage et le maintien en position se ferait alors en vissant la plaque de fermeture dans l'ouverture d'insertion 12.

Comme représenté schématiquement sur la figure 1 et plus en détail sur la figure 2, les moyens d'ouverture de la cellule d'évaporation 10 comportent ici un pointeau de perforation 18 situé à l'extrémité de la portion amont 15 du conduit d'injection 14 se trouvant dans la chambre d'évaporation 100.

Le pointeau de perforation 18 vient ici de formation avec cette portion amont 15 mais on peut prévoir en variante que ce pointeau de perforation soit formé d'une pièce rapportée sur la portion amont, par exemple par vissage ou par emboîtement en force.

Ce pointeau de perforation 18 est destiné à percer l'opercule 116 étanche de l'enveloppe sous vide du creuset 110. L'opercule 116 est alors conçu pour être rompu lors de l'introduction du creuset 110 dans la chambre d'évaporation 100. Par exemple, l'opercule 116 du creuset 110 peut être formé par une membrane fine en verre, ou en quartz permettant, lorsqu'il n'est pas percé, une étanchéité suffisante de l'enveloppe du creuset 110.

Grâce à la forme pointue du pointeau de perforation 18 et à la force exercé par celui-ci sur l'opercule 116, celui-ci se brise de sorte qu'une ouverture d'échappement est ménagée dans l'enveloppe du creuset 110.

Cette ouverture d'évaporation permet alors de mettre le creuset 110 en communication avec la chambre d'évaporation 100.

Plus précisément, l'ouverture d'évaporation met en communication le volume intérieur 119 du creuset 110 en communication avec le conduit d'injection 14 de la cellule d'évaporation 10, au travers ici de deux trous d'échappement 18A qui sont ménagés dans la portion amont 15 du conduit d'injection 14, juste au-dessus du pointeau de perforation 18 et qui, après engagement du creuset 110 dans la chambre d'évaporation 100, sont situés dans le volume intérieur 119 dudit creuset 110.

De cette façon, lors de l'évaporation du matériau 7 contenu dans le creuset 110 chauffé par les moyens d'évaporation 131, 132, le flux de vapeur généré 118 dans le creuset 110 est conduit dans la portion amont 15 du conduit d'injection 14 *via* ces trous d'échappement 18A.

On va maintenant décrire en détail un exemple de mise en oeuvre de l'appareil de dépôt sous vide 1 utilisant ce premier mode de réalisation de la cellule d'évaporation 10. Ceci fera comprendre les avantages d'une telle cellule d'évaporation 10 et notamment son intérêt pour la réduction des pics de pression lors des changements de creuset.

Au début du procédé de dépôt, le substrat 2 étant placé dans la partie basse 23 de la chambre de dépôt sous vide 20, on ferme la vanne d'arrêt 17 de la cellule d'évaporation 10 si elle n'est pas déjà fermée. Dans cette configuration, le volume intérieur 29 de la chambre de dépôt sous vide 20 et le volume intérieur 19 de l'enceinte externe 11 de la cellule d'évaporation 10 sont en communication mais sont isolés du volume intérieur 109 de la chambre d'évaporation 100 grâce à la vanne d'arrêt 17. On réalise alors grâce à la pompe 6 le pompage de la chambre de dépôt sous vide 20 et de l'enceinte externe 11 jusqu'à ce que la pression atteigne un niveau compris entre 10⁻³ et 10⁻⁸ Torr.

Parallèlement à ce pompage, on met en route les résistances chauffantes 16 de l'enceinte externe 11 de manière à chauffer la vanne d'arrêt 17, le conduit d'injection 14 et sa portion amont 15 jusqu'à une température comprise entre 15°C et 500°C.

On met également les moyens d'évaporation 131, 132 en route de manière à ne pas créer de gradient de température trop important à l'intérieur de la cellule d'évaporation 10.

On prépare aussi un premier creuset 110 contenant le matériau 7 à évaporer, avec son enveloppe mise sous vide et scellée grâce à l'opercule 116.

Lorsque le niveau de pression requis est atteint dans la chambre de dépôt sous vide 20 et lorsque les différents éléments de la cellule d'évaporation 10 ont été chauffés jusqu'au niveau de température nécessaire, on peut alors procéder à l'engagement du premier creuset 110 avec la chambre d'évaporation 100.

Pour cela, on fait passer le creuset 110 au travers de l'ouverture de passage 12 de l'enceinte externe 11, ici confondue avec l'ouverture d'insertion 12 de l'enceinte interne 100, pour introduire vers le haut le creuset 110 dans la chambre d'évaporation 100.

Cette introduction est réalisée de préférence au moyen de la plaque de fermeture 105 sur laquelle repose le creuset 110. De cette façon, lorsque l'opercule 116 vient à être brisé par le pointeau de perforation 18 à la faveur de l'introduction du creuset 110 dans l'enceinte interne 100, la plaque de fermeture 105 grâce à son joint périphérique 105A obture en configuration fermée l'ouverture d'insertion 12 de la chambre d'évaporation 100.

Ainsi, la seule quantité d'air à pression ambiante emprisonnée lors de l'engagement du creuset 110 avec la chambre d'évaporation 100 est celle qui est comprise dans le volume résiduel 109 compris entre l'enceinte interne 100 de la cellule d'évaporation 10 et l'enveloppe du creuset 110 (voir figure 2 par exemple) accueilli dans la chambre d'évaporation 100.

De préférence, selon l'invention, les dimensions respectives de la chambre d'évaporation 100 et du creuset 110 sont ajustées de sorte que ce volume résiduel 109 est inférieur au volume intérieur 119 du creuset 110.

De cette façon, on s'assure que la pression régnant dans le volume résiduel 109 et dans le volume additionnel 159 délimité par la portion amont 15 du conduit d'injection 14 comprise entre la chambre d'évaporation 100 et la vanne d'arrêt 17 (voir figure 1) est le plus proche possible de celle régnant dans le creuset 110 avant perforation de l'opercule 116.

Ainsi, lors de l'ouverture de la vanne d'arrêt 17, le pic de pression est limité.

De manière avantageuse, la vanne d'arrêt 17 peut être placée au plus près de la chambre d'évaporation 100 afin de limiter le volume additionnel 159.

Encore plus préférentiellement, les dimensions respectives de la chambre d'évaporation 100 et du creuset 110 sont ajustées de sorte que la somme du volume résiduel 109 et du volume additionnel 159 est inférieure au volume intérieur 119 du creuset 110.

De cette façon, le pic de pression est encore plus limité.

Après engagement du creuset 110, on met celui-ci en conditions d'évaporation grâce aux résistances électriques 131 et à l'écran thermique 132 de manière à générer un flux de vapeur 118 dans le conduit d'injection 14.

On peut alors ouvrir la vanne d'arrêt 17 de manière à laisser le flux de vapeur amont 3 (voir figure 1) s'écouler jusqu'à l'injecteur 13 qui diffuse le flux de vapeur aval 4 en direction du substrat 2 placé dans la chambre de dépôt sous vide 20 pour déposer le matériau 7 évaporé sur la surface supérieure 2A du substrat 2.

Lorsque le premier creuset 110 est vide suite à l'évaporation complète du matériau 7, on ferme la vanne d'arrêt 17 de manière à isoler la chambre de dépôt sous vide 20 de la chambre d'évaporation 100 et éviter de la remettre à l'air. On peut alors retirer le premier creuset 110 et le remplacer par un creuset plein selon le même procédé.

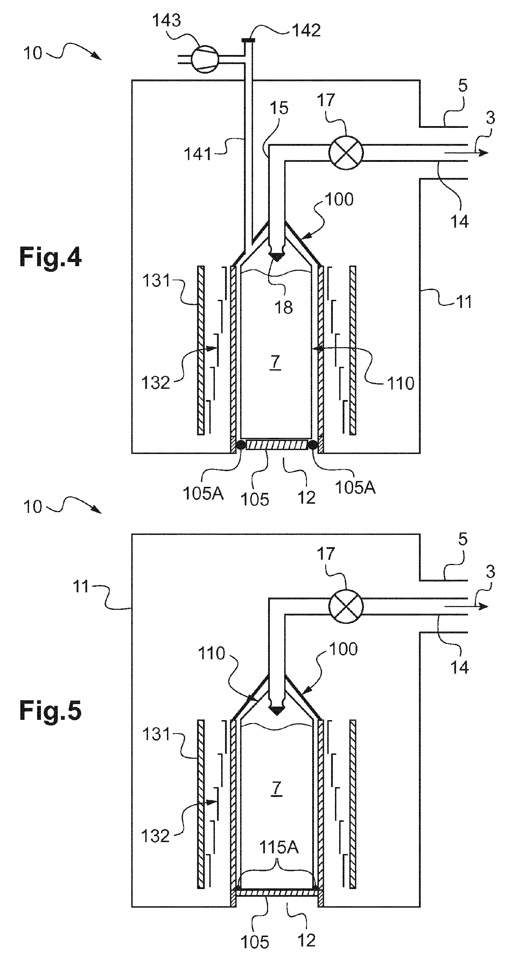

Avantageusement, dans une variante de la cellule d'évaporation 10 représentée sur la figure 4, on peut prévoir une pompe supplémentaire 143 de l'enceinte interne 100 qui sont, par exemple, raccordée à celle-ci au moyen d'un tuyau de raccordement 141 piqué sur le col 102 de l'enceinte interne 100.

Cette pompe supplémentaire 143 permet de faire le vide dans la chambre d'évaporation 100 avant ouverture de la vanne d'arrêt 17, pour réduire encore le pic de pression.

Dans une autre variante, représenté ici sur la figure 4 en combinaison avec la précédente sans que cela soit limitatif, on peut prévoir une soupape d'échappement 142 de l'enceinte interne 100 qui est ici montée sur le tuyau de raccordement 141, en dérivation de la pompe supplémentaire 143.

Cette soupape d'échappement permet de remettre à l'air la chambre d'évaporation 100 avant désengagement du creuset 110 de sorte que ce désengagement soit rendu plus facile.

Dans une autre variante encore du premier mode de réalisation représentée sur la figure 5, on peut prévoir un creuset 110 comprenant dans sa partie basse, près de son fond 115, un joint périphérique 115A destiné à réaliser l'étanchéité de la chambre d'évaporation 100. Dans ce cas, les moyens d'obturation comprennent alors ledit joint périphérique 115A du creuset 110 ainsi qu'une plaque de fermeture destinée ici à bloquer et maintenir en position le creuset 110 dans la chambre d'évaporation 100.

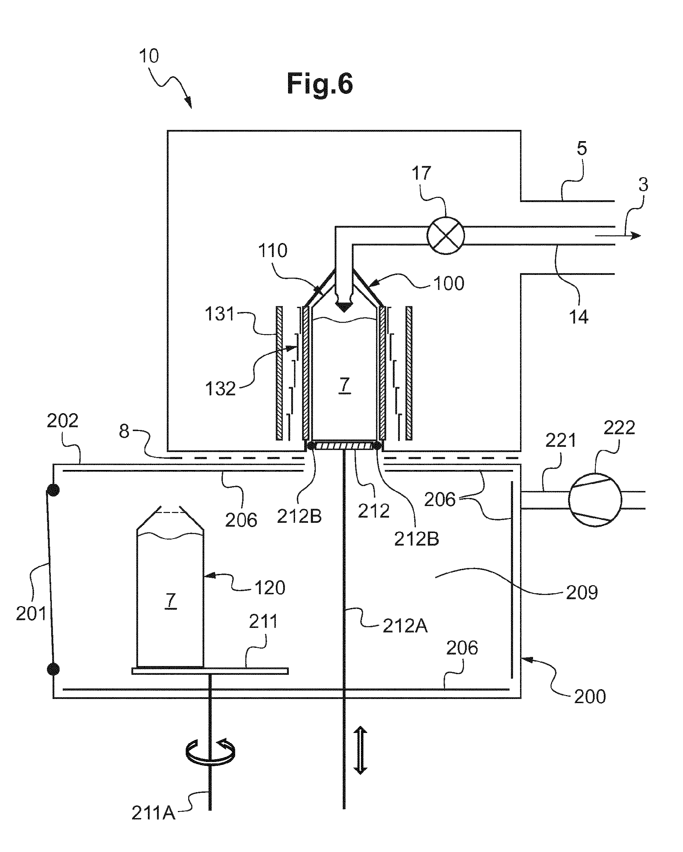

Dans un deuxième mode de réalisation de la cellule d'évaporation 10, représenté sur la figure 6, la cellule d'évaporation 10 comporte en outre une chambre de chargement 200 attenante à la chambre d'évaporation 100 pour l'engagement et le désengagement du premier creuset 110 d'avec la chambre d'évaporation 100.

Cette chambre de chargement 200 comprend en particulier ici une enceinte de confinement 202 et une trappe d'accès 201 permettant l'introduction des creusets à l'intérieur de cette enceinte de confinement 202.

Comme pour l'enceinte externe 11 de la cellule d'évaporation 10, on peut prévoir, sur les faces internes de l'enceinte de confinement 202, des éléments chauffants, par exemple des résistances chauffantes 206, destinés à chauffer de façon sensiblement homogène le volume intérieur 209 de l'enceinte de chargement, et en particulier les différents éléments qui peuvent s'y trouver comme les creusets 110, 120.

L'enceinte de confinement 202 de la chambre de chargement 200 comprend sur sa paroi supérieure une ouverture située en regard de l'ouverture d'insertion 12 portant la chambre d'évaporation 100, de sorte que la chambre de chargement 200 est en communication avec la chambre d'évaporation 100 au travers de cette ouverture d'insertion 12 lorsque celle-ci n'est pas obturée.

La chambre de chargement 200 comporte par ailleurs une pompe additionnelle 222 branchée sur l'enceinte de confinement 202 *via* un conduit de pompage 221 pour mettre sous vide ladite chambre de chargement 200, par exemple lorsque celle-ci a été remise à l'air par l'ouverture de la trappe d'accès 201.

Dans la chambre de chargement 200, il est par ailleurs prévu des moyens de chargement et de déchargement des creusets 110, 120, ici un système de carrousel et piston.

Plus précisément, la chambre de chargement 200 comporte tout d'abord un piston 212A à l'extrémité supérieure duquel est fixé un plateau 212 destiné à accueillir le premier creuset 110 ou le deuxième creuset 120.

Le piston 212A est mobile en translation verticale, de sorte que le plateau 212 peut monter et descendre le long de l'axe du piston 212A, entre :
- une position « basse » dans laquelle le plateau 212 est proche de la paroi inférieure de l'enceinte de confinement 202, et
- une position « haute » (cas de la figure 6) dans laquelle le plateau 212 se situe au niveau de l'ouverture d'insertion 12 de la cellule d'évaporation 10.

La position basse permet le chargement ou le déchargement du plateau 212 avec un creuset 110, 120.

Une fois le creuset 110 en place sur le plateau 212, celui-ci peut monter verticalement grâce au piston 212A et engager ainsi le creuset 110 avec la chambre d'évaporation 100 en passant au travers de l'ouverture d'insertion 12 de la cellule d'évaporation 10.

La chambre de chargement 200 comporte également un carrousel 211 monté dans la chambre de chargement 200 pour tourner autour d'un axe de rotation 211 A permettant d'entraîner en rotation le carrousel 211.

Ce carrousel 211 est destiné à recevoir les creusets pour leur chargement et leur déchargement du plateau 212.

La position angulaire du carrousel 211 est commandée par un moteur (non représenté) piloté pour emmener successivement chacun des creusets 110, 120 chargés sur le plateau 212 au droit du plateau 212 et de son piston 212A de manoeuvre.

Le système de carrousel 211 et plateau 212 est particulièrement avantageux car il offre un encombrement réduit pour un nombre de creusets donné. Ainsi, la taille de chambre de chargement 200 et les capacités de pompage de la pompe additionnelle 222 branchée sur la chambre de chargement 200 peuvent être limitées.

Il est prévu des moyens de blindage thermique qui s'interposent entre l'enceinte externe 11 de la cellule d'évaporation 10 et la chambre de chargement 200.

Plus précisément, ces moyens de blindage thermique comprennent ici une bride de connexion 8 permettant l'accroche de la paroi inférieure 11C de l'enceinte externe 11 à la paroi supérieure de la chambre de chargement 200. Cette bride de connexion 8 comporte ici un réseau de serpentins parcourus par un liquide de refroidissement (eau, azote, etc...).

Cette bride de connexion 8 permet notamment d'isoler thermiquement la chambre d'évaporation 100 de la chambre de chargement 200 et d'éviter que la chaleur dégagée par les différents moyens de chauffage 16 de la cellule d'évaporation 10 n'ait un effet perturbateur sur un creuset 110, 120 placé dans la chambre de chargement 200, et *vice versa* afin de ne pas perturber le gradient thermique dans le creuset 110, 120 en cours d'évaporation.

De cette façon, il est possible de retirer « à chaud » le premier creuset 110 de la chambre d'évaporation 100 lorsqu'il est chaud, sans attendre son refroidissement. Le deuxième creuset 120 peut ainsi être introduit dans la chambre d'évaporation 100 dès le retrait du premier creuset 110, et l'évaporation peut reprendre dès la mise à température de ce deuxième creuset 120.

Par ailleurs, grâce aux moyens de blindage thermique 8, il est possible de charger le deuxième creuset 120 dans la chambre de chargement 200 pendant que l'évaporation du premier creuset 110 est en cours, et ce malgré la chaleur dégagée par les moyens d'évaporation 131, 132 qui chauffent le premier creuset 110. Cette chaleur dégagée est sans effet thermique notable et néfaste sur le deuxième creuset 120 se trouvant dans la chambre de chargement 200. En particulier, la température du matériau 7 à évaporer présent dans le creuset 120 reste inférieure à la température d'évaporation du matériau 7.

Dans ce deuxième mode de réalisation, les moyens d'obturation de l'ouverture d'insertion 12 sont donc formés par le plateau 212 muni de son joint périphérique 212B, comme le joint 105A de la plaque de fermeture 105.

L'un des principaux avantages d'une telle cellule d'évaporation 10 est que, grâce à l'utilisation de la chambre de chargement 200, lors de l'engagement d'un nouveau creuset dans la chambre d'évaporation 100, l'air emprisonné dans l'enceinte interne 100 avec le creuset 110, 120 peut être à une pression bien inférieure à la pression atmosphérique, grâce notamment à la pompe additionnelle qui aura fait le vide dans l'enceinte de confinement 202 avant introduction du creuset dans la chambre d'évaporation 100.

Un autre avantage de l'utilisation d'une cellule d'évaporation 10 avec une chambre de chargement 200 est que les temps d'interruption du procédé de dépôt sont réduits puisque le rechargement de la chambre de chargement 200 peut se faire lors de l'évaporation d'un creuset engagé avec la chambre d'évaporation 100 et qu'une mise en conditions d'évaporation préalable des creusets chargés dans la chambre de chargement 200 peut se faire grâce aux résistances chauffantes 206. De cette façon, un flux de vapeur est plus rapidement obtenu après engagement du creuset dans la chambre d'évaporation 100.

Enfin, les temps d'interruption peuvent être même complètement supprimés en utilisant une cellule d'évaporation comportant plusieurs chambres d'évaporation munies chacune de leur vanne d'arrêt respective.

De cette façon, un creuset vide peut être remplacé alors qu'un creuset encore rempli de matériau est en cours d'évaporation.

## Revendications

1. Cellule d'évaporation (10) destinée à évaporer un matériau (7) en vue de son dépôt sur un substrat (2) placé dans une chambre de dépôt sous vide (20), comportant :
- une enceinte interne délimitant une chambre d'évaporation (100) adaptée à accueillir un creuset (110) contenant ledit matériau (7) à évaporer, cette enceinte interne (100) présentant une ouverture d'insertion (12) du creuset (110) dans ladite chambre d'évaporation (100),
- des moyens d'évaporation (101, 131, 132) disposés à la périphérie de ladite enceinte interne (100) et adaptés à mettre ledit creuset (110) en conditions d'évaporation pour l'évaporation du matériau (7) contenu dans ledit creuset (110), lorsque celui-ci est accueilli dans ladite chambre d'évaporation (100),
- un conduit d'injection (14) adapté à transporter un flux de vapeur (3) du matériau (7) évaporé depuis la chambre d'évaporation (100) jusqu'à un injecteur (13) situé dans ladite chambre de dépôt sous vide (20), et
- une vanne d'arrêt (17) placée sur ledit conduit d'injection (14), **caractérisée en ce qu'**elle comporte :
- des moyens d'obturation (105, 105A) de ladite ouverture d'insertion (12) de l'enceinte interne (100) de la cellule d'évaporation (10), ces moyens d'obturation (105, 105A) présentant :
- une configuration ouverte permettant l'insertion dudit creuset (110) dans ladite chambre d'évaporation (100), et
- une configuration fermée dans laquelle la chambre d'évaporation (100) est confinée et en communication avec la chambre de dépôt sous vide (20) *via* le conduit d'injection (14) lorsque la vanne d'arrêt (17) est ouverte, et
- des moyens d'ouverture (18) adaptés à ménager une ouverture d'évaporation dans une enveloppe (111, 112, 115, 116) dudit creuset (110) qui est remplie du matériau (7) à évaporer et maintenue sous vide avant ouverture, ladite ouverture d'évaporation permettant de mettre ledit creuset (110) en communication avec ladite chambre d'évaporation (100).

2. Cellule d'évaporation (10) selon la revendication 1, dans laquelle, lorsque ladite ouverture d'insertion (12) est obturée par les moyens d'obturation (105, 105A) en configuration fermée et que, après insertion, ledit creuset (110) est accueilli dans ladite chambre d'évaporation (100), les dimensions respectives de ladite chambre d'évaporation (100) et dudit creuset (110) sont ajustées de sorte que le volume résiduel (109) compris entre ladite enceinte interne (100) de la cellule d'évaporation (10) et ladite enveloppe du creuset (110) est inférieur au volume intérieur (119) dudit creuset (110).

3. Cellule d'évaporation (10) selon la revendication 1, dans laquelle, lorsque ladite ouverture d'insertion (12) est obturée et que ledit creuset (110) est accueilli dans ladite chambre d'évaporation (100), les dimensions respectives de ladite chambre d'évaporation (100) et dudit creuset (110) sont ajustées de sorte que la somme du volume résiduel (109) compris entre ladite enceinte interne (100) de la cellule d'évaporation (10) et ladite enveloppe du creuset (110) et du volume additionnel (159) délimité par la portion du conduit d'injection (14) comprise entre ladite chambre d'évaporation (100) et ladite vanne d'arrêt (17) est inférieure au volume intérieur (119) dudit creuset (110).

4. Cellule d'évaporation (10) selon l'une des revendications 1 à 3, comportant une enceinte externe (11) enveloppant ladite enceinte interne (100), lesdits moyens d'évaporation (101, 131, 132), et ladite vanne d'arrêt (17) et présentant une ouverture de passage en regard ou confondue avec ladite ouverture d'insertion (12) de l'enceinte interne (100) pour permettre le passage dudit creuset (110) en vue de son insertion dans ladite chambre d'évaporation (100).

5. Cellule d'évaporation (10) selon l'une des revendications 1 à 4, dans laquelle lesdits moyens d'obturation (105, 115A) de la cellule d'évaporation (10) passent de leur configuration ouverte à leur configuration fermée à la faveur de l'insertion dudit creuset (110) dans ladite chambre d'évaporation (100).

6. Cellule d'évaporation (10) selon l'une des revendications 1 à 5, dans laquelle lesdits moyens d'obturation (105, 105A) de la cellule d'évaporation (10) comprennent une plaque de fermeture (105) munie d'un élément de joint (105A) destiné à réaliser l'étanchéité entre ladite plaque de fermeture (105) et ladite enceinte interne (100).

7. Cellule d'évaporation (10) selon l'une des revendications 1 à 6, dans laquelle lesdits moyens d'ouverture (18) de la cellule d'évaporation (10) comprennent un pointeau de perforation (18) destiné à percer un opercule (116) étanche de ladite enveloppe sous vide du creuset (110).

8. Cellule d'évaporation (10) selon l'une des revendications 1 à 7, dans laquelle il est prévu des moyens de pompage supplémentaires (141, 143) de ladite enceinte interne (100) qui sont adaptés à faire le vide dans ladite chambre d'évaporation (100).

9. Cellule d'évaporation (10) selon l'une des revendications 1 à 8, dans laquelle il est prévu des moyens d'échappement (141, 142) de ladite enceinte interne (100) qui sont adaptés à remettre à l'air ladite chambre d'évaporation (100).

10. Cellule d'évaporation (10) selon l'une des revendications 1 à 9, comportant en outre une chambre de chargement (200) attenante à la chambre d'évaporation (100) pour l'engagement et le désengagement dudit creuset (110) d'avec la chambre d'évaporation (100), ladite chambre de chargement (200) étant en communication avec la chambre d'évaporation (100) au travers de ladite ouverture d'insertion (12).

11. Cellule d'évaporation (10) selon la revendication 10, dans laquelle il est également prévu des moyens de blindage thermique (8) qui s'interposent entre ladite enceinte externe (11) et ladite chambre de chargement (200) et qui sont adaptés à isoler thermiquement ladite chambre d'évaporation (100) de ladite chambre de chargement (200).
